# EUROPEAN PATENT SPECIFICATION

(11) **EP 1 553 449 B1**
(45) Date of publication and mention of the grant of the patent: **20.01.2016**
(21) Application number: 03766620.3
(22) Date of filing: 04.07.2003
(51) Int. Cl.: G03F 7/038

(54) **ACTIVE ENERGY RAY SENSITIVE RESIN COMPOSITION, ACTIVE ENERGY RAY SENSITIVE RESIN FILM AND METHOD FOR FORMING PATTERN USING SAID FILM**
AKTIVENERGIESTRAHLENEMPFINDLICHE HARZZUSAMMENSETZUNG, AKTIVENERGIESTRAHLEMPFINDLICHER HARZFILM UND VERFAHREN ZUR HERSTELLUNG EINER STRUKTUR UNTER VERWENDUNG DES FILMS
COMPOSITION DE RESINE SENSIBLE AU RAYONNEMENT D'ENERGIE ACTIVE, COUCHE MINCE DE RESINE SENSIBLE AU RAYONNEMENT D'ENERGIE ACTIVE, ET PROCEDE PERMETTANT DE FORMER UN MOTIF AU MOYEN DE CETTE COUCHE MINCE

(30) Priority: 04.07.2002 JP 2002196577
(43) Date of publication of application: 13.07.2005
(73) Proprietor: Murakami Co., Ltd., Sumida-ku, Tokyo 130-0003 (JP); Ichimura, Kunihiro, Yokohama-shi, Kanagawa 226-0016 (JP)
(72) Inventor: ICHIMURA, Kunihiro, Midori-ku, Yokohama-shi, Kanagawa 226-00 (JP); MORITA, Tomoyuki, MURAKAMI CO., LTD., Sumida-ku, Tokyo 130-0003 (JP); KAWANOBE, Junichi, MURAKAMI CO., LTD., Sumida-ku, Tokyo 130-0003 (JP); ADACHI, Daisaku, MURAKAMI CO., LTD., Sumida-ku, Tokyo 130-0003 (JP); INOUE, Kazuo, MURAKAMI CO., LTD., Sumida-ku, Tokyo 130-0003 (JP)
(74) Representative: Mai, Dörr, Besier
(86) International application number: PCT/JP2003/008539
(87) International publication number: WO 2004/013700

(56) References cited:
- EP-A1- 0 423 446
- GB-A- 2 137 626
- JP-A- 7 146 549
- JP-A- 9 203 806
- JP-A- 9 319 079
- US-A- 4 341 859
- US-A- 4 341 859
- US-A- 4 564 580

## Description

### Technical Field:

This invention relates to an activation energy ray-sensitive resin composition which comprises an acid former generating an acid by the action of activation energy rays and dispersed in an aqueous solution of a water-soluble resin in the presence or absence of a sensitizer, to which an acid-reactive insolubilizing agent is added, to an activation energy ray-sensitive resin film obtainable from the above composition, and to a method for forming a pattern using the film.

### Background Art:

An activation energy ray-sensitive resin or resin composition is utilized for a covering treatment etc. for a surface of an image forming substrate by utilizing its change in chemical structure created by the action of activation energy rays such as light, infrared rays, far-infrared rays, electron beams or X-rays. Among activation rays, light is widely used. For this reason, the following descriptions occasionally specifically refer to light as the activation energy rays. However, the activation energy rays utilized in the composition and films obtainable from the composition according to the present invention are not limited to light.

Resins or compositions thereof which are sensitive to light are utilized in many fields and in large quantities as pattern forming materials having high resolution in photolithography technology, etc. (see "Photopolymer Technology", edited by YAMAOKA, Tsuguo and MATSUNAGA, Gentaro, Nikkan Kogyo Shimbun Ltd.(1988)) Polymer-type photosensitive materials, which not only have good resolution but also permit setting of a wide photosensitive region by selecting the wavelengths of light, are utilizable depending upon their intended applications. Further, they have an important role in that the resin layer thereof patterned by irradiation with light serves to function as a resist material in the case of a chemical, physical or mechanical etching treatment of the substrate. Further, they are actually used as a platemaking material for letterpress printing, intaglio printing, lithography or stencil printing. By virtue of these characteristics, they are utilized as photolithography process materials encompassing a wide range from submicrons to centimeters.

In the case of a polymer-type photosensitive resin, patterns are formed through a development treatment which utilizes a change in physical properties, such as solubility, caused as a result of a change in chemical structure in the exposed or unexposed region. When the resin is used as a material for a surface covering treatment, a change in chemical structure caused by light exposure induces a significant change in physical property thereof to express the function of protection of a substrate. Such a change in chemical structure of the resin is not attributed to the photochemical reaction alone. Rather, the change is based on a total of chemical reactions inclusive of various secondary reactions induced by the photochemical reaction. Thus, for example, it is possible to arbitrarily select the solubility of a resin layer in a solvent before and after light exposure. Namely, when the solubility of the exposed region decreases, the resin serves as a negative-type photosensitive resin by a solvent developing treatment. When the solubility of the exposed area is improved, then the resin serves as a positive-type photosensitive resin.

When patterning is effected by the development with a solvent, it is indispensable to use water as a solvent which is cheapest and safest, since it is directly related to environmental problems including work environment and waste treatment. When water which is neutral and which has high polarity is used as a solvent, it is required that the material to be dissolved therein should be also high in polarity. Therefore, examples of photosensitive resin capable of being developed with neutral water are restricted as will be described hereinafter.

From the foregoing viewpoint, the production of photosensitive films using neutral water by itself as a solvent and the provision of a photosensitive resin or a photosensitive resin composition capable of being developed with neutral water alone have been long expected. However, there are available limited number of photosensitive resins capable of being developed with neutral water as will be described hereinafter. Whilst a photosensitive resin which comprises a water-soluble polymer, such as gelatin, casein or poly(vinyl alcohol), and a dichromate added thereto has been practically used from the past, the utilization thereof has been restricted or excluded, since it contains heavy metal ions and since it has poor preservation stability. Similarly, a photosensitive resin using a water-soluble diazo resin as a photo-crosslinking agent and containing the water-soluble polymer as shown above has been widely utilized. However, the utilizable range of the resin is limited because the photosensitivity is lower than the dichromate-type photosensitive resin, because the resin is ill-suited for a thick photosensitive layer due to coloring of the exposed area and resulting reduction in light transmittance thereof and because the problem in long-term preservation stability still remains unsolved. Further, there has been proposed a composition containing an emulsion of an ethylenically unsaturated compound and a photopolymerizable initiator in poly(vinyl alcohol), and a photo-crosslinking agent blended to the emulsion (Japanese Unexamined Patent Publications No. S49-121852, No. S50-108003, No. S59-107343, etc.). The composition, however, is unsatisfactory with respect to the water resisting property, since no crosslinkages are formed in poly(vinyl alcohol) itself.

Materials containing poly(vinyl alcohol) to which hydrophilic residues, representative of which is styrylpyridinium, are bonded have been proposed as a water-soluble photosensitive polymer that has solved the foregoing problems (Japanese Unexamined Patent Publications No. S55-23163, No. S55-62905, No. 58-25303, etc.). These materials have merits that the sensitivity thereof is higher than that of the above-described water-developing-type photosensitive resins and the preservation stability thereof is excellent and, therefore, are used as pattern forming materials, representative of which is a screen platemaking material. However, since the water-insolubilization of the photosensitive polymer is attained only by photo-dimerization reaction, there occurs no great change in physical properties, representative of which is hydrophilicity, although a change in solubility in neutral water before and after the light exposure is significant. As a consequence, when the polymer is used as a printing platemaking material, it has poor resistance to an aqueous ink. In this circumstance, an improvement of the physical property of the polymer is devised by using various additives. For example, compositions blended with an aqueous emulsion are proposed in Japanese Unexamined Patent Publications No. S55-62446, No. S60-10245, No. S61-17141, No. 56-122784, No. S60-10245, etc. However, problems in various physical properties such as water resistance and mechanical strengths still remain unsolved.

Thus, there is widely adopted a method in which, likewise quinonediazido-type resist material and chemical proliferation-type resist material, an acidic group such as a carboxyl group or a phenolic hydroxyl group is produced by the catalytic action of an acid generated as a result of photochemical reaction, the acidic group being utilized for the solubilization in an aqueous alkali solution. With this method, a positive-type or negative-type pattern can be formed by a development treatment with an aqueous alkali solution (see C. P. Wong, Polymers for Electronic and Photonic Applications, Academic Press, p.67 (1993)). Because these constituents are insoluble or sparingly soluble in water, the composition is prepared into a solution in an organic solvent. As a consequence, there arises a problem that the organic solvent evaporates and is scattered during the coating of a film. In a photolithographic process in which production is carried out in an extremely large quantity, it is necessary to neutralize the developing liquid before discard. Additionally, depending upon the intended use, there arises a problem that the physical properties of the pattern resist layer deteriorate, since acidic groups having a high polarity are formed in the exposed area. On the other hand, a method is also proposed in which alkaline residues, representative of which is an amino group, are formed by photochemical reaction and in which development is carried out using acidic water. Since, however, a film coating step using an organic solvent must be included in this method, it is unavoidable to carry out a neutralizing treatment likewise in the alkali development.

Thus, in photosensitive compositions containing a photo-acid generating agent as its component, it is a general practice to dissolve the acid generating agent in a solvent or other liquid component. As a consequence, when the solvent for the photosensitive composition and the solvent for development are limited to water, it is necessary that the photo-acid generating agent or a photosensitizer thereof should be soluble in water. Japanese Unexamined Patent Publication No. H09-319080 proposes a water-developable photosensitive composition containing poly(vinyl alcohol), a crosslinking agent and a water-soluble photo-acid generating agent. The composition has a problem because the kind of the water-soluble acid generating agent is restricted and because the acid generated is a carboxylic acid which is low in acidity. On the other hand, Japanese Unexamined Patent Publication No. H10-62990 proposes a photosensitive composition for screen printing which is developable with water and which is prepared by emulsifying a liquid epoxy resin compound into an aqueous solution of poly(vinyl alcohol) containing a cationic photoinitiator to form an oil-in-water type emulsion. In actual, however, the composition is added with a diazo resin or dichromate as a water-soluble photo-crosslinking agent or the composition uses poly(vinyl alcohol) into which a photo-crosslinkable stilbazolium group has been introduced. The reason is considered to be that, because the liquid epoxy resin containing the cationic photoinitiator is emulsified in the aqueous solution of poly(vinyl alcohol), the reaction of the acid generated by irradiation of a resin film made of the composition with the hydroxyl groups of the poly(vinyl alcohol) which is in a discontinuous phase from the epoxy resin does not easily occur, though the acid generated can induce the cationic polymerization of the epoxy resin. Thus, the proposed composition has a problem that crosslinking does not sufficiently proceed in the absence of the photo-crosslinking agent.
D1 = US 4 341 859 A discloses the use of a water-insoluble or sparingly water-soluble acid former, wherein the acid former is dissolved in an organic solvent, the resulting solution in turn being dispersed in the form of colloidal droplets. Hence, the acid former is in the form of solved droplets dispersed in water.
D2 = GB 2 137 626 A discloses an aqueous dispersion utilizing insolubilization reaction of cationically curable compound, such as an epoxy resin, using a photoinitiator such as an onium salt.
D2 does not anticipate or suggest insolubilization of a water-soluble resin by acid-catalyzed cross-linking. Although the composition of D2 may contain a water-soluble resin such as poly (vinyl alcohol), the function of the resin is to enhance stability of the emulsion.

The objective problem of the present invention is to provide an activation energy ray-sensitive resin composition which is capable of being developed with neutral water, an activation energy ray-sensitive resin film obtainable from the composition, and a pattern forming method using the film.

### Disclosure of the Invention

The present inventors have made an earnest study with a view to solving the above-described problems and, as a result, have accomplished the present invention.

In accordance with the present invention, there are provided an activation energy ray-sensitive resin composition which is capable of being developed with neutral water, an activation energy ray-sensitive resin film which is capable of being developed with neutral water, and a pattern forming method as follows.
(1) An activation energy ray-sensitive resin composition comprising:
   water,
   a water-soluble resin dissolved in the water,
   an acid former, in the form of solid particles, dispersed in the water and generating an acid when irradiated with activation energy rays,
   a sensitizer, in the form of solid particles, dispersed in the water for sensitizing the acid generation by the acid former, and
   an acid-reactive insolubilizing agent dissolved or dispersed in the water and capable of insolubilizing said water-soluble resin by reaction therewith in the presence of said acid,
   wherein said acid-reactive insolubilizing agent is an N-methylolated or N-alkoxymethylated nitrogen-containing compound, a hydroxymethylated phenol derivative or a resol resin; a compound having at least one oxetane group, vinyloxy group, isopropenyloxy group or orthoester group; or a compound having at least one formyl group, wherein each of said acid former and sensitizer has an average particle diameter of 1,5 µm or less.
(2) The composition as recited in (1), further comprising a compound having at least one radically polymerizable unsaturated bond and dissolved or dispersed in the water.
(3) The composition as recited in (1), wherein said acid-reactive insolubilizing agent is a mixture of a compound, having at least one oxetane group with a compound having at least one epoxy group.
(4) The composition as recited in any of (1) to (3), further comprising an aqueaous resin emulsion.
(5) The composition as recited in any of (1) to (4), further comprising a water-soluble, photo-insolubilizable resin.
(6) The composition as recited in (5), wherein said water-soluble, photo-insolubilizable resin is a photo-crosslinkable polyvinyl alcohol containing a styrylpyridinium group represented by the following formula (1): 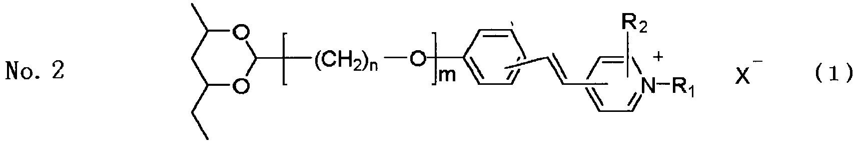 wherein R₁ represents a hydrogen atom, an alkyl group or an aralkyl group, R₂ represents a hydrogen atom or a lower alkyl group, X·represents a halogen ion, a phosphate ion, a p-toluenesulfonate ion or a mixture of these anions, m is a number of 0 or 1 and
   n is an integer of 1 to 6.
(7) The composition as recited in any one of (1) through (6) above, characterized in that said water-soluble, photo-insolubilizable resin comprises poly(vinyl alcohol), casein or gelatin, and a water-soluble diazo resin or a dichromate.
(8) The composition as recited in any preceding of (1) through (7), wherein said acid-reactive insolubilizing agent is present in an amount of 5 to 1,000 parts by weight per 100 parts by weight of saidwater-soluble resin, said acid former is present in an amount of 1 to 100 parts by weight per 100 parts by weight of said-reactive insolubilizing agent, and said sensitizer is present in an amount of 5 to 100 parts by weight per 100 parts by weight of said acid former.
(9) The composition as recited in any preceding of (1) through (8), wherein each of said former and sensitizer has an average particle diameter of 0.8 µm or less.
(10) An activation energy ray-sensitive resin film obtainable by drying a layer of the composition according to any one of (1) through (9).
(11) Use of the resin film of (10) for screen printing process.
(12)A pattern forming method comprising the steps of: irradiating an activation energy ray-sensitive resin film according to (10) with activation energy rays, and developing the activation energy ray-irradiated film with water.
(13) A pattern forming method as recited in lcaim 12, further comprising heating the activation energy ray-irradiated resin film before said developing with water.

### Best Mode for Carrying Out the Invention

As the water-soluble resin serving as a dispersing agent for finely dispersing the acid former and/or sensitizer in the present invention, there may be used any naturally occurring polymer, semi-synthetic polymer and synthetic polymer (refer to "Development Techniques of Water-Soluble Polymers", CMC (1999)). As the naturally occurring polymer, there may be mentioned chitin, chitosan, casein, collagen, albumen, starch, carrageenan, xanthan gum, dextran, pullulan, etc. As the semi-synthetic polymer, there may be mentioned dialdehyde starch, partial hydrolysate of starch, hydroxyethyl starch, cyclodextrin, dextrin, carboxymethyl cellulose, methyl cellulose, hydroxyethyl cellulose, hydroxypropyl cellulose, etc. As the synthetic polymer, there may be mentioned poly(vinyl alcohol), partially saponified poly(vinyl alcohol), poly(vinyl alcohol) acetalized such that the water solubility is not lost, poly(vinylpyrrolidone) and copolymers thereof, polyacrylamide and copolymers thereof, N-isopropylacrylamide and copolymers thereof, acrylamide and copolymers thereof,N, N-dimethylacrylamide and copolymers thereof, poly(N-acetylvinylamine), polyethylene glycol, etc.

Polymers having basic residues may also be used for the purpose of the present invention, since a reduction of acidity of the acid generated from the acid former can be prevented by adjusting the pH of the aqueous solution at about 7. However, it is more preferred that the water-soluble polymer chains are free of amino groups which are basic residues or that the amount of amino groups be as small as possible. It is also preferred that the water-soluble polymers contain functional groups capable of reacting with the acid-reactive insolubilizing agent such as hydroxyl groups. In this regard, starch, dialdehyde starch, methyl cellulose, hydroxyethyl cellulose, hydroxypropyl cellulose, poly(vinyl alcohol), polyacrylamide, hydroxyethyl acrylate copolymers, hydroxyethyl methacrylate copolymers, water-soluble N-methylolated nylon, etc. are suitably used. Since these water-soluble polymers also serve to function as a dispersant for the solid photo-acid former, cationic residues may be introduced thereinto.

These water-soluble resin may be added as a binder resin to a fine dispersion of the acid former and/or sensitizer. Further, these water-soluble binder resins may be used together with a diazo resin or a dichromate as a photo-crosslinking agent. Furthermore, a photo-crosslinkable poly(vinyl alcohol), disclosed in Japanese Unexamined Patent Publications No. S55-23163, No. 55-62905, etc. and containing a styrylpyridinium group represented by the general formula (1) shown below, may be suitably used as the binder resin:

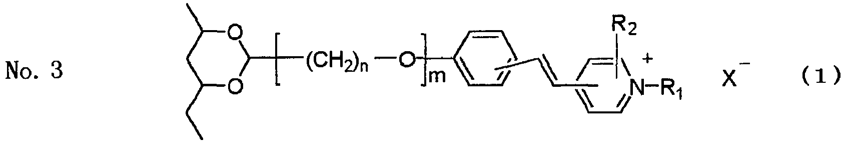

In the above formula, R₁ represents a hydrogen atom, an alkyl group or an aralkyl group, R₂ represents a hydrogen atom or a lower alkyl group, X⁻ represents a halogen ion, a phosphate ion, a p-toluenesulfonate ion or a mixture of these anions, m is a number of 0 or 1 and n is an integer of 1 to 6.

The alkyl group R₁ has 1 to 6 carbon atoms, preferably 2 to 4 carbon atoms.

The aralkyl group R₁ has 7 to 13 carbon atoms, preferably 7 to 10 carbon atoms. The aralkyl group is derived from various aromatic compounds (benzene compounds, naphthalene compounds, anthracene compounds, etc.) having alkyl groups.

The lower alkyl group R₂ has 1 to 4 carbon atoms, preferably 1 to 2 carbon atoms.

As the acid former generating an acid by the action of activation energy rays according to the present invention, there may be used compounds utilized in chemical amplification-type photoresists or in cationic photopolymerization (refer to "Organic Materials for Imaging", edited by Organic Electronics Material Study Group, Bunshin Shuppan (1993)). As the acid former used in the present invention, there may be mentioned a cationic onium compound, a halogen-containing compound which generates a hydrogen halide, and a sulfonated compound which generates sulfonic acid. These compounds are insoluble or sparing soluble in water. Examples of suitable compounds are shown below.

As the ionic acid former, there may be mentioned salts of onium cations, such as diazonium, ammonium, iodonium, sulfonium, phosphonium or ferrocenium, with Cl⁻, Br⁻, I⁻, ZnCl₃⁻, HSO₃⁻, BF₄⁻, PF₆⁻, AsF₆⁻, SbF₆⁻, CH₃SO₃⁻, CF₃SO₃⁻, perfluorobutanesulfonate, perfluorooctanesulfonate, camphorsulfonate, benzenesulfonate, p-toluenesulfonate, 9,10-dimethoxyanthracene-2-sulfonate, cyclohexylamino sulfonate, (C₆F₅)₄B⁻, (C₄H₉)₄B⁻, etc.

Specific examples of the onium cation include phenyldiazonium, p-methoxy diazonium, α-naphthyldiazonium, biphenyldiazonium, diphenylamine-4-diazonium, 3-methoxydiphenylamine-4-diazonium, 2,5-diethoxy-4-methoxybenzoylamidophenyldiazonium, 2,5-dipropoxy-4-(4-tolyl)thiophenyldiazonium, 4-methoxydiphenylamine-4-diazonium, condensate of 4-diazodiphenylamine and formaldehyde, 1-methoxyquinolinium, 1-ethoxyisoquinolinium, 1-phenacylpyridinium, 1-benzyl-4-benzoylpyridinium, 1-benzylquinolinium, N-substituted benzothiazolium (refer to Japanese Unexamined Patent Publication No. H05-140143), etc.

Further, there may be mentioned benzyltriphenyl sulfonium, p-methoxyphenydiphenyl sulfonium, bis(p-methoxypheny)phenyl sulfonium, tris(p-methoxypheny) sulfonium, p-phenylthiophenyldiphenyl sulfonium, benzyltetramethylene sulfonium, phenacyltetramethylene sulfonium, phenacyldimethyl sulfonium, p-methoxyphenydiethyl sulfonium, naphthyldialkyl sulfonium (refer to Japanese Unexamined Patent Publications No. H09-118663 and No. H05-140209), (2-naphthylcarbonylmethyl)-tetramethylene sulfonium, (p-hydroxyphenyl)dimethyl sulfonium, (4-hydroxynaphthyl)dimethyl sulfonium, (4,7-dihydroxynaphthyl)-1-dimethyl sulfonium, (4,8-dihydroxynaphthyl)-1-dimethyl sulfonium, diphenyl iodonium, phenyl(4-methoxypheny) iodonium, phenyl{4-(tert-butyl)phenyl}iodonium, 4-bis{4-(tert-butyl)phenyl} iodonium, bis(4-dodecylphenyl) iodonium, (4-methoxyphenyl)-4-octyloxyphenyl) iodonium, phenacyltriphenyl phosphonium, cyanomethyltriphenyl phosphonium, etc.

Examples of the acid former generating a halogenated hydroacid include 1-methyl-3,5-bis(trichloromethyl)-s-triazine, 1-phenyl-3, 5-bis(trichloromethyl)-s-triazine, 1-(4-chlorophenyl)-3, 5-bis(trichloromethyl)-s-triazine, 1-(4-methoxypheny)-3, 5-bis(trichloromethyl)-s-triazine, 1-(4-butoxyphenyl)-3, 5-bis(trichloromethyl)-s-triazine, 1-(3, 4-methylenedioxyphenyl)-3,5-bis(trichloromethyl)-s-triazine, 1-(3,4-dimethoxyphenyl)-3, 5-bis(trichloromethyl)-s-triazine, 1-(4-methoxynaphthyl-1)-3, 5-bis(trichloromethyl)-s-triazine, 1-{2-(4-methoxypheny)ethenyl}-3,5-bis(trichloromethyl)-s-triazine, 1-{2-(2-methoxypheny)ethenyl}-3,5-bis(trichloromethyl)-s-triazine, 1-{2-(3,4-dimethoxyphenyl)ethenyl}-3, 5-bis(trichloromethyl)-s-triazine, 1-{2-(3-chloro-4-methoxypheny)ethenyl}-3,5-bis(trichloromethyl)-s-triazine, 1-(biphenyl-1)-3,5-bis(trichloromethyl)-s-triazine, 1-(4-hydroxybiphenyl-1)-3,5-bis(trichloromethyl)-s-triazine, 1-(4-methoxybiphenyl-1)-3,5-bis(trichloromethyl)-s-triazine, 1-(4-methylbiphenyl-1)-3,5-bis(trichloromethyl)-s-triazine, 1,3,5-tris(trichloromethyl)-s-triazine, 1,3-dichloro-4-trichloromethylbenzene, 1,1,1-trichloro-{2,2-84-chlorophenyl}ethane, phenyltribromomethyl sulfone, 1-keto-4-methyl-4-trichloromethyl-2,5-dichlorohexadiene, 2-tribromoquinoline and 1-keto-2,3-benzo-4,4,5,6-tetrachlorohexadiene.

As the acid former generating sulfonic acid, there may be mentioned 2-nitrobenzyl-p-toluene sulfonate, 2,6-dinitrobenzyl-p-toluene sulfonate, 1-(p-toluenesulfonyloxyimino)-1-phenylethane nitrile, 1-(p-toluenesulfonyloxyimino)-1-phenylethanenitrile, benzoin-p-toluenesulfonate, 2-p-toluenesulfonyloxy-2-benzoylpropane, p-nitrobenzyl-9,10-dimethoxyanthracene-2-sulfonate, N-trifluoromethanesulfonyloxydiphenylmaleimide, N-p-toluenesulfonyloxysuccinimide, N-camphorsulfonyloxysuccinimide, N-trifluoromethanesulfonyloxysuccinimide, N-perfluorobutanesulfonyloxysuccinimide, N-p-toluenesulfonyloxyphthalimide, N-camphorsulfonyloxyphthalimide, N-trifluoromethanesulfonyloxyphthalimide, N-perfluorobutanesulfonyloxyphthalimide, N-p-toluenesulfonyloxy-1,8-naphthalenecarboxyimide, N-camphorsulfonyloxy-1,8-naphthalenecarboxyimide, N-trifluoromethanesulfonyloxy-1,8-naphthalenecarboxyimide, N-perfluorobutanesulfonyloxy-1,8-naphthalenecarboxyimide, 1,2,3-tris(p-toluenesulfonyloxy)benzene, bis(phenylsulfone), bis(phenylsulfonyl)methane, etc.

The above-described acid formers which are insoluble or sparingly soluble in water are used by being finely dispersed in the aqueous solution of the water-soluble resin. Therefore, the acid generated by activation energy rays can easily diffuse in the water-soluble resin. As a consequence, the acid-catalyzed reaction of the acid-reactive insolubilizing agent and the water-soluble resin is facilitated so that the insolubilization of the resin can efficiently proceed.

In the present invention, whilst the acid formers exemplified above can generate, by themselves, the corresponding acid by the action of activation energy rays, the acid can be also generated when irradiated, in the presence of a spectrum sensitizer, with light which can be absorbed by the sensitizer. The spectrum sensitizer used for the purpose of the present invention is desirably insoluble or sparingly soluble in water. Thus, the desired objects may be achieved when the acid former is dispersed together with the sensitizer in the form of fine powder. It is unexpected that the sensitized acid forming reaction efficiently occurs to cause the insolubilization even when not only the acid former but also the sensitizer is in the form of dispersed solids.

The sensitizer used in the present invention is preferably an electron donating compound in view of the fact that the above-exemplified acid formers function as an electron donor, as described in Japanese Unexamined Patent Publications No. S54-151024, No. S58-40302, No. S60-76740, No. S60-78443, No. S60-88005, No. S60-112802, No. S61-97650, No. S61-180359, No. S62-161820 and No. S63-243102. As the sensitizer having such a property and suitable for the present invention, there may be mentioned, but not limited thereto, an aromatic polycyclic compound, a porphyrin compound, a phthalocyanine compound, a polymethine dye compound, a merocyanine compound, a coumarin compound, a thiopyrylium compound, a pyrylium compound, a p-dialkylaminostyryl compound, a thioxanthene compound, etc. Most of these compounds are disclosed in "Dye Handbook" (Kodansha) edited by Ookawara, Hirashima, Matsuoka and Kitao; "Handbook of Coloring Material Engineering" (Asakura Publishing (1989)), edited by the Japan Society of Coloring Material; and "Dye Catalogue" of Hayashibara Biochemical Laboratories Photosensitive Dye Lab.

As the aromatic polycyclic compound, there may be mentioned those which have a basic skeleton of a hydrocarbon such as naphthalene, phenanthrene, pyrene, anthracene, tetracene, chrysene, pentacene, picene, coronene, hexacene or ovalene. Also, aromatic five-membered ring heteropolycyclic compounds containing an oxygen atom, a nitrogen atom or a sulfur atom as their constituent atoms, such as benzofuran, dibenzofuran, indole, carbazole, benzothiophene and dibenzothiophene, may be mentioned. Usable aromatic six-membered ring heteropolycyclic compounds have a basic skeleton of, for example, α-benzopyrone, β-benzopyrone, α-thiabenzopyrone, β-thiabenzopyrone, flavone, xanthone, thioxanthone, phenoxazine or phenothiazine. These basic skeletons may have at least one electron donating group, as a substituent, such as an alkyl group, a hydroxyl group, an alkoxy group or an alkylthio group. Examples of the sensitizer of substituted aromatic polycyclic compound include 1-methoxynaphthalene, 1,4-dimethylnaphtalene, 1,8-dimethylnaphtalene, 9,10-dimethylphenanthrene, 9-methylanthracene, 9,10-dimethylanthracene, 9,10-diphenylanthracene, 9,10-bis(phenylethynyl)anthracene, 1,8-dimethyl-9,10-bis(phenylethynyl)anthracene, 9,10-dimethoxyanthracene, 9,10-diethoxyanthracene, 9,10-dipropoxyanthracene, 9,10-dibutoxyanthracene, 1-methylpyrene. As the substituted polycyclic heterocyclic compound, there may be mentioned N-methylcarbazole, N-ethylcarbazole, thioxanthone, isopropylthioxanthone, etc.

The porphyrin compound may be a compound having a basic skeleton of, for example, tetraphenylporphine, octaethylporphine, mesoporphyrin, protoporphyrin, hematoporphyrin, chlorin, tetrabenzoporphine, phenyl-substituted tetrabenzoporphine, a magnesium complex thereof, a zinc complex thereof. Also, there may be mentioned chlorophyll.

The phthalocyanine compound may be a naphthocyanine compound and may have at least one substituent, such as an alkyl group, an alkoxy group, an alkylthio group, an aryl group and a halogen group, introduced into its basic skeleton. Further, as a central metal, magnesium, zinc, cadmium or aluminum is particularly preferred.

As thepolymethine dye compound, a cyanine-series or merocyanine-series compound having such a structure in which a heterocycle containing a nitrogen atom, an oxygen atom, a sulfur atom, etc. is connected by polymethine can be used. For example, compounds disclosed in "Dye Handbook" edited by Makoto OOKAWARA, Teijiro KITAO, Tsuneaki HIRAOKA and Ken MATSUOKA, (Kodansha Scientific (1986)), pages 382-417 may be mentioned. Specific examples of the dye compounds include a cyanine-series which comprises a quinoline ring, an indiocyanine-series which comprise an indole ring, a thiocyanine-series which comprises a benzothiazole ring, and a polymethine-series which compreses an iminocyclohexadiene ring, and, additionally, a benzoxazole-series, a pyrylium-series, a thiapyrylium-series, a squarylium-series, a croconium-series.

As the coumarin compound, there may be mentioned monocoumarin compounds described in "Dye Handbook" edited by Makoto OOKAWARA, Teijiro KITAO, Tsuneaki HIRAOKA and Ken MATSUOKA, (Kodansha Scientific (1986)), pages 432-438 and, additionally, 3-(2-benzothiazolyl)-7-(diethylamino)coumarin, 3-(2-benzothiazolyl)-7-(dibutylamino)coumarin, 3-(2-benzothiazolyl)-7-(dioctylamino)coumarin, 3-(2-benzo imidazolyl)-7-(diethylamino)coumarin, 10-(2-benzothiazolyl)-2,3,6,7-tetrahydro-1,1,7,7-tetramethyl-1H,5H,11H-[1]benzopyrano[6,7,8-ij]quinolyzin-11-on, 3,3-carbonylbis(7-diethylaminocoumarin), 3,3-carbonylbis(7-dibutylaminocoumarin), etc.

As the p-dialkylaminostyryl compound, there may be mentioned 4-diethylaminobenzylideneacetophenone, 4-diethylaminobenzylidene(p-methoxy)acetophenone, 4-diethylaminobenzylidenemalondinitrile, 4-dimethylaminobenzylideneacetoacetic ethyl ester, 4-dimethylaminobenzylidenemalonic acid diethyl ester, 4-dimethylaminobenzylidene-α-cyanoacetophenone, 2,6-bis(4-dimethylaminobenzylidene)cyclohexanone, 4-dimethylaminocinnamylideneacetophenone, 4-dimethylaminocinnamylidenemalondinitrile, 4-dimethylaminocinnamylidenecyanoacetic acid ethyl ester, 4-dimethylaminocinnamylidenemalonic acid diethyl ester, 4-dimethylaminocinnamylidene-α-cyanoacetophenone, 4-dimethylaminocinnamylidenebis(4-dimethylaminobenzylidene)cyclohexanone, etc.

The absorption wavelengths of these spectrum sensitizers encompass a wide range from those of ultraviolet rays to those of infrared rays. Thus, they can be used singly or as a mixture of two or more thereof so that light of a wide range of wavelengths can be efficiently absorbed for the generation of the acid.
The term "acid-reactive insolubilizing agent" as used herein is intended to refer to a compound which causes dehydrative condensation reactions, addition reactions, cationic polymerization reactions, etc. by the catalytic action of an acid generated by the action of activation energy rays, so that the water-soluble resin contained in the composition is insolubilized through crosslinking, polymerization, etc. In particular, it is preferred that the insolubilizing agent be acid-catalytically bonded to the main chain or side chain cites of the water-soluble resin. The insolubilizing agent may be soluble, insoluble or sparingly soluble in water. An insolubilizing agent which is insoluble or sparingly soluble in water may be used in the form of a dispersion. The insolubilizing agents which will be exemplified below may be used alone or as a mixture of two or more thereof.

As an insolubilizing agent which undergoes dehydrative condensation with alcoholic hydroxyl groups of poly(vinyl alcohol), cellulose derivatives, polysaccharides such as starch, N-methylolated nylon, etc. as the water-soluble resin, there may be mentioned N-hydroxymethylacrylamide, N-hydroxymethylated urea, N-hydroxymethylated malonamide, N-hydroxymethylated phthalamide, hexahydroxymethylated melamine, p-hydroxymethylphenol, o-hydroxymethylphenol, 2,6-bis(hydroxymethyl)-p-cresol, resol resin, etc. Derivatives of these compounds in which the hydroxymethyl group is replaced by an alkoxymethyl group having 1-6 carbon atoms may also be used.

As an insolubilizing agent which undergoes addition reaction with alcoholic hydroxyl groups of poly(vinyl alcohol), cellulose derivatives, polysaccharides such as starch, and derivatives thereof as the water-soluble resin, a compound having at least one oxetane group optionally in mixture with a compound having at least one epoxy group may be suitably used. Such a compound causes also cationic polymerization and is particularly preferred. As the insolubilizing agent having two or more glycidyl-type epoxy groups used in a mixture with a compound having at least one oxetane group, there may be mentioned EX-611, EX-612, EX-614, and EX-614B EX-614, EX-622, EX-512, EX-521, EX-411, EX-421, EX-313, EX-314, EX-321, EX-201, EX-211, EX-212, EX-252, EX-810, EX-811, EX-850, EX-851, EX-821, EX-830, EX-832, EX-841, EX-861, EX-911, EX-941, EX-920, EX-721, EX-221, EM-150, EM-101 and EM-103, which are DENAKOL-series products described in a catalog of Nagase Chemtex Co., Ltd.; YD-115, YD-115G, YD-115CA, YD-118T and YD-127, which are described in a catalog of Toto Kasei Co., Ltd.; and 40E, 100E, 200E, 400E, 70P, 200P, 400P, 1500NP, 1600, 80MF, 100MF, 4000, 3002 and 1500, which are EPOLITE-series products described in a catalog of Kyoeisha chemical Co., Ltd. As an alicyclic epoxy compound to be used in a mixture with a compound having at least one oxetane group, there may be mentioned CELOXIDE 2021, CELOXIDE 2080, CELOXIDE 3000, EPOLEAD GT300, EPOLEAD GT400, EPOLEAD D-100ET, EPOLEAD D-1000T, EPOLEAD D-100DT, EPOLEAD D-100ST, EPOLEAD D-200HD, EPOLEAD D-200E, EPOLEAD D-204P, EPOLEAD D-210P, EPOLEAD D-210P, EPOLEAD PB3600, EPOLEAD PB4700, etc. described in a catalog of Daicel Chemical Industries, Ltd.

As a monofunctional epoxy compound to be used in a mixture with a compound having at least one oxetane group, there may be mentioned EX-111, EX-121, EX-141, EX-145, EX-146, EX-171, EX-192, EX-111 and EX-147, which are DENAKOL-series products described in a catalog of Nagase Chemtex Co., Ltd.; and M-1230, EHDG-L and 100MF which are EPOLITE-series products described in a catalog of Kyoeisha chemical Co., Ltd. By using these substances as a reactive diluent, a highly viscous or solid epoxy resin can be used. For example, BPF-type epoxy resins, BPA-type epoxy resins, BPF-type epoxy resins, novolak-type epoxy resins, brominated-type epoxy resins and flexible-type resins, which are described in a catalog of Tohto Kasei Co., Ltd.; EPIKOTE basic solid-type and EPIKOTE bis-F solid-type described in a catalog of Yuka Shell Epoxy Kabushiki Kaisha; and EHPE alicyclic-type solid epoxy resins described in a catalog of Daicel Chemical Industries, Ltd. can be used.

As an oxetane compound, there may be used compounds described in J. V. Crivello and H. Sasaki, J. M. S. Pure Appl. Chem., A30 (2&3), 189 (1993) or J. H. Sasaki and V. Crivello, J. M. S. Pure Appl. Chem., A30 (2&3), 915 (1993). For example, OXT-101 OXT-121, OXT-211, OXT-221, OXT-212, OXT-611, etc. of Toa Gosei, Inc. can be mentioned. These oxetane compounds may be used as a mixture with the above-mentioned epoxy compound.

As an insolubilizing agent which causes cationic polymerization, there may be mentioned, in addition to the above epoxy groups and oxetane groups, monomers having a vinyl ether group, a propenyl ether group or a cyclic ortho-ester group. As vinyl ether, there may be mentioned butane diol divinyl ether, hexane diol divinyl ether, cyclohexane diol divinyl ether, diethylene glycol monovinyl ether, diethylene glycol divinyl ether, hydroxybutyl vinyl ether, hydroxyethyl vinyl ether, octadecyl vinyl ether, butanediol monovinyl ether.

In the composition according to the present invention, a compound having at least one, more preferably at least two, formyl groups or acetal groups can be used as an acid reactive insolubilizing agent, when using polyvinyl alcohol as the water-soluble resin. In this case, acetalization takes place on the poly(vinyl alcohol) chain with an acid generated serving as a catalyst, so that the water-solubility thereof is lost. Examples of the compound having a formyl group include salicylaldehyde, m-hydroxybenzaldehyde, p-hydroxybenzaldehyde, terephthalaldehyde, terephthalaldehyde bisethyl acetal, terephthalaldehyde bisethylene acetal, terephthalaldehyde trimethylene acetal, glutaraldehyde bisdiethyl acetal and glutaraldehyde bisethylene acetal.

A compound having at least one light-active ethylenically unsaturated bond may be dissolved or dispersed in the photosensitive composition of the present invention. By containing such a compound, not only an acid is generated by the decomposition of photo-acid former but also radical species are generated together, so that the composition is imparted with an ability to initiate radical polymerization. The light-active ethylenically unsaturated compound is a compound having at least one radically polymerizable unsaturated bond such as an acryloyl group, a methacryloyl group or an allyl group. The ethylenically unsaturated compound involves a prepolymer or an oligomer having a molecular weight of 10,000 or less.

As the unsaturated compound, there may be mentioned pentaerythritol (meth)acrylate, pentaerythritol tetra (meth)acrylate, trimethylolpropane tri(meth)acrylate, triallyl isocyanurate, lauryl (meth)acrylate, methoxyethylene glycol (meth)acrylate, 2-ethylhexyl (meth)acrylate, benzyl (meth)acrylate, hexyl diglycol (meth)acrylate, ethylene glycol di(meth)acrylate, diethylene glycol di(meth)acrylate, trimethylene ethylene glycol di(meth)acrylate, tetramethylene glycol di(meth)acrylate, pentamethylene glycol di(meth)acrylate, hexamethylene glycol di(meth)acrylate, ethylene glycol diglycidyl ether (meth)acrylate, phenyl glycidyl ether (meth)acrylate, trimethylolpropane polyglycidyl ether (meth)acrylate, terephthalic acid diglycidyl ether (meth)acrylate, a reaction product of tolylene diisocyanate and 2-hydroxypropyl (meth)acrylate, a reaction product of phenyl isocyanurate and 2-hydroxyethyl (meth)acrylate and an unsaturated polyester with a molecular weight of 10000 or less and having an ethylenically unsaturated bond such as a maleic acid ester of glycol.

These light-active unsaturated compounds may be used singly or in combination of two or more and are used in an amount of 0.5 to 5 parts, preferably 0.1 to 3 parts, per 1 part of the water-soluble resin.

These radically polymerizable compounds generate not only acids but also radical species when irradiated with light in the presence of a photo-acid former alone or in combination with a sensitizer. Therefore, polymerization takes place to cause solubilization. Additionally, a known radical photoinitiator may be cojointly used to facilitate the photo-radical reaction.

Next, a method for dispersing the above-described constituents in an aqueous solution of a water-soluble resin so as to obtain the composition of the present invention will be described.

The acid former and sensitizer which is used, if necessary, by mixing therewith are sparingly soluble or insoluble in water and are dispersed in an aqueous solution of a water-soluble resin after having been previously finely ground and further pulverized into fine powder. Alternately, these substances are pulverized in an aqueous solution of a water-soluble resin into fine powder to obtain a suspension in which they are finely dispersed in a solid state. Since the composition of the present invention is used as a water suspension liquid, it is preferred that the acid former and/or sensitizer be finely dispersed in water. Therefore, as a dispersant, the water-soluble resin is suitably used, though a surfactant, etc. may be used together.

Thus, the present invention is characterized in that the photo-acid former in a solid state is dispersed in water in the form of fine powder. To this end, known fine pulverization methods, fine dispersion methods and apparatuses therefor used for the manufacture of coating materials, pigments, inks, paints, various coatings, electronic materials, magnetic materials, pharmaceuticals, agricultural chemicals, cosmetics, food, etc. may be utilized.

These methods and apparatuses are disclosed in, for example, Taiichi TSURITANI and Masumi OISHI, "Industrial Dispersing Technique", Nikkan Kogyo Shimbun Ltd. (1985); Noboru MORIYAMA, "Chemistry of Dispersion and Aggregation", Sangyo Tosho Publishing (1995), p. 150-154; "Fine Particle Control" edited by Society of Chemical Engineers, Japan, Maki-Shoten Publishing (1996), p. 1-14; "Coating", edited by Processing Technique Study Group, Processing Technique Study Group (2002), p. 84-139. Namely, devices such as a colloid mill, a ball mill, a sand mill, a bead mill, three roll mill and, additionally, a kneader, an extruder and a high speed disperser may be used singly or in combination. In dry type fine pulverizing of the acid former and/or sensitizer, the pulverized fine powder are dispersed in an aqueous solution of a water soluble resin. In this case, the water soluble resin itself serves as a dispersant. If desired, a low molecular weight or high molecular weight surfactant may be also added as a dispersant. In the case of wet pulverizing, since the pulverization and fine-dispersion are carried out in an aqueous solution of a water-soluble resin, a photosensitive composition can be easily prepared from the suspension itself. In this case, too, a surfactant can be added in order to efficiently perform the dispersion.

The following methods may be employed for the dry-type or wet-type pulverization of the photo-acid former in the presence of the spectral sensitizer:

In the first method, solids of the photo-acid former and sensitizer are pulverized together into fine powder in an aqueous solution of a water-soluble resin and dispersed therein. Namely, the photo-acid former and sensitizer in the form of a mixture are subjected to a dry or wet fine pulverization treatment.

In the second method, the acid former and sensitizer in the solid state are separately finely dispersed in aqueous solutions of a water-soluble resin. Then, the resulting dispersions are mixed together.

Whilst the present inventors expected that, when a photo-acid as a solid is finely dispersed and the dispersion is irradiated with activation energy rays, an acid is generated. However, it is unexpected that sensitized acid-generation reaction occurs even when both the photo-acid former and the sensitizer are in the form of solids. That is, it is said that in order for an electron transfer reaction or an energy transfer, which is a sensitization reaction, to take place, it is necessary that the intermolecular distance between a molecule which gives electron or excitation energy (the molecule will be referred to as "donor molecule") and a molecule which receives the electron or excitation energy (the molecule will be referred to as "acceptor molecule") should be up to about 10 angstroms. For this reason, it has been the general practice that the donor molecule and the acceptor molecule are combined into the same molecule, or are dissolved to have a molecule concentration higher than a predetermined level. It is therefore surprising that sensitization reaction occurs and, hence, the sensitization rate of high sensitivity is obtainable, even though the photo-acid former and the sensitizer are present in the composition of the present invention in the dispersed state as solids because they are sparingly soluble or insoluble in water. It is inferred that the acid former and the sensitizer might form an eutectic during the course of mixing and finely dispersing them, or might form a solid solution with the acid-reactive insolubilizing agent and water-soluble resin during the course of a film forming process.

Although the particle size of the acid former and/or sensitizer to be dispersed varies with the method and purpose of dispersing, the average particle diameter thereof is 1.5 µm or less, preferably 0.8 µm or less. The particle size of the dispersed acid former and/or sensitizer has distribution. Therefore, photosensitivity is expressed even when the average particle diameter is, for example, 1.0 µm because of the presence of finer particles. If desired, after fully pulverizing and finely dispersing the acid former and/or sensitizer in an aqueous solution of a water-soluble resin, large particles of the acid former and/or sensitizer may be removed by centrifugal separation or by filtration with a glass filter or a membrane filter, etc. It is known that a transparent coloring agent is obtainable by removing the pigment particles having greater than a certain particle size, as described in Japanese Unexamined Patent Publication No. S60-129707. In the case of the present invention, too, a photosensitive composition in which the light scattering effect is remarkably reduced can be obtained by removing large particles of the photo-acid former and sensitizer.

It is desirable to add an antifoaming agent during or after the finely dispersing the acid former and/or sensitizer in an aqueous solution of a water-soluble resin. As the antifoaming agent suitable for the photosensitive composition of the present invention, there may be used antifoaming agents of a silicone-type and, additionally, antifoaming agents of an alcohol-type, an ether-type, a metallic soap-type, an ester-type and a higher fatty acid-type, as described in "Application of Antifoaming Agent", Tsunetaka SASAKI (editorial supervision), CMC (1991).

The thus obtained composition may be further added with a water-soluble binder resin to control the properties, such as viscosity, of the photosensitive composition and to improve the properties of a photosensitive film, such as mechanical strengths, sensitivity and water resistance. As the binder resin, the water-soluble resin used as a dispersant can be used. It is desirable that the resin have a high polymerization degree.

The formulation of the photosensitive composition of the present invention is such that the amount of the acid-reactive insolubilizing agent is 5 to 1,000 parts, preferably 10 to 500 parts, per 100 parts of the water-soluble resin serving as a dispersant and a binder resin; the amount of the acid former is 1 to 100 parts, preferably 5 to 50 parts, per 100 parts of the acid-reactive insolubilizing agent; the amount of the sensitizer is 5 to 100 parts, preferably 10 to 50 parts, per 100 parts of the acid former; and the total amount of these ingredients is 5 to 400 parts, preferably 10 to 200 parts, per 100 parts of water. When the amount of the acid former and the acid-reactive insolubilizing agent is less than the above ranges, sufficient photo-insolubilization does not occur, while the photo-insolubilization rate will not change even when the amounts thereof increase beyond the above ranges. When the amount of the sensitizer is less than the above range, sufficient sensitization effect is not obtainable. Even when the sensitizer is added beyond the above range, the sensitization rate does not increase but, rather, the light transmittance is undesirably reduced.

To the photosensitive composition of the present invention, a finely dispersed extender such as aluminum oxide, silicon oxide, titanium oxide or zinc white may be added. An organic pigment which does not give a sensitization effect to the acid former, such as a copper, nickel or iron complex of phthalocyanine, may also be added thereto.

To the photosensitive composition of the present invention, an aqueous resin emulsion the containing a dispersoid of hydrophobic polymer particles can be added. As the hydrophobic polymer which constitutes such an aqueous resin emulsion, there may be used poly(vinyl acetate), a polyvinyl acetate/ethylene polymer, a polyvinyl acetate/acrylic ester polymer, a styrene/butadiene copolymer, a methyl methacrylate/butadiene copolymer, an acrylonitrile/butadiene copolymer, a chloroprene copolymer, an isoprene copolymer, a poly(meth)acrylic resin, polyurethane, a polyester resin, poly(vinyl chloride), poly(vinylidene chloride), polystyrene, a silicone resin, polyethylene, a fluororesin, etc. These resin emulsions are used in an amount of 0.05 to 5 parts, preferably 0.1 to 3 parts, per 1 part of the water-soluble resin.

The photosensitive composition of the present invention is suitable for forming a coating (resin film) on any substrate such as wood; textiles; paper; ceramics; glass; a synthetic resin, e.g. polyester, polyolefin, cellulose acetate, polyimide and epoxy resin; glass fiber reinforced resin; a metal, e.g. aluminum, copper, nickel, iron, zinc, magnesium and cobalt; a semiconductor material, e.g. silicon and gallium-arsenide-germanium; and an insulating material, e.g. silicon nitride and silicon oxide. It is desirable that the substrate be subjected to a hydrophilicity imparting treatment beforehand especially in the case of synthetic resin for the purpose of improving the film forming efficiency thereof. A pattern or a protective layer may be formed by irradiating the coating, made of the photosensitive composition of the present invention and formed on these substrates, with light.

The composition may be applied on a surface of the substrate by any known method capable of forming an uniform coating, such as by rotation coating, brushing, spraying, reverse roll coating, a dip coating, doctor knife coating or curtain coating. The thickness of the film may ranges from 0.1 µm to 1,000 µm in terms of average thickness, thought the thickness is dependent on the purpose, on the kind of the substrate and on the particle size of the acid former or sensitizer.

The photosensitive composition applied on the substrate is exposed to light after evaporating water. The sensitization wavelength region is determined by the kind of the acid former and the sensitizer. Since a wide range of sensitizers can be used, the wavelength of light ranges from far ultraviolet ray region to an infrared region. As the light source, there may be suitably used low pressure mercury lamp, a high pressure mercury lamp, a super-high pressure mercury lamp, a xenon lamp, a mercury-xenon lamp, a halogen lamp, a fluorescent lamp and, else, various laser light sources which oscillate ultraviolet rays, visible ray and infrared rays. The exposure may be done through a photo mask. Alternatively, the photosensitive film may be directly written with laser beam. Furthermore, it is without saying that the exposure can be carried out using activation energy rays such as electron beams and X-rays.

The phosensitive film which has been subjected to light exposure is insoluble in water. To facilitate the insolubilization, the light exposure may be followed by a heat treatment. The temperature used in the heat treatment may vary depending upon the kind of the substrate but is generally in the range from room temperature to 250°C, preferably in the range from room temperature to 150°C. The heat treatment time depends upon the kind of the photosensitive composition and heating temperature but is 30 seconds to 60 minutes.

The film which has been subjected to the light exposure and, if necessary, the heat treatment is developed with neutral water. The development may be achieved by immersing the photosensitive film in water for the dissolution and removal of the unexposed area or by contacting water flows from a spray gun for the removal of the unexposed area.

A screen printing plate may be prepared by a conventional method which includes applying the photosensitive composition of the present invention over a screen, followed by drying, light exposure and development. Alternatively, a screen printing plate may also be prepared by a conventional method which includes applying the photosensitive composition on a plastic film, drying the coating to obtain a photosensitive film for preparing a screen printing plate, applying the film on a screen plate using water, etc., drying the assembly, removing the plastic film, followed by light exposure and development.

Further, the activation energy ray-sensitive composition of the present invention may be used as an aqueous coating material. Thus, the composition is applied on a surface of a substrate, the coating being irradiated with ultraviolet rays, visible light, near infrared rays or an electron beam to harden the surface.

### Industrial Applicability:

Since the activation energy ray-sensitive composition, an activation energy ray-sensitive film obtainable from the composition and a pattern forming method according to the present invention have the above-described constitution, the following effects are obtained.
(1) Since only water is used as a solvent for preparation of the activation energy ray-sensitive composition and for development treatment, the composition is suited for ensuring the safety of work environment, fire prevention, prevention of pollution, etc.
(2) Since the acid former can generate an acid not only by the action of light but also by the action of activation energy rays such as electron beams or X-rays, the composition is not only sensitive to light but also sensitive to electron beams and X-rays.
(3) Since various sensitizers can be used together, the composition obtained may be sensitive to rays of a wide wavelength ranging from the far ultraviolet ray region to a near infrared ray region.
(4) The composition can be applied to a film or a screen substrate to form an activation energy ray-sensitive film which serves as a photosensitive film capable of storing for a long period of time.
(5) A pattern of high resolution can be obtained by adjusting the particle size of the water-insoluble or sparingly water-soluble acid former and the sensitizer to a small size.
(6) The composition can provide a surface coating material hardenable by light exposure or electron beam irradiation.
(7) The activation energy ray-sensitive composition and a film obtainable therefrom are advantageously utilized in the field of printing such as screen printing platemaking and also advantageously used as a coating composition, an adhesive composition, etc.

### Examples:

The present invention will be next described in further detail by examples.

### Examples 1 to 12

### Preparation Dispersions of Photo-Acid Former and Sensitizer:

A dispersion of a photo-acid former was prepared using a planetary-type fine pulverizer (Model P-7 manufactured by Fritsch Inc., Germany) and 45 mL pulverizing vessel made of stainless steel or zirconia in the following manner.

Poly(vinyl alcohol) (PVA, manufactured by Nihon Gosei Kagaku Co., Ltd.) as a dispersant was dissolved in water to obtain a 15 % by weight aqueous solution. The aqueous solution (15 mL) and a photo-acid former and/or sensitizer were charged in the pulverizing vessel, to which about 15 mL of stainless steel or zirconia pulverizing beads having a diameter of 5/32 inches and made of the same material as that of the pulverizing vessel and an antifoaming agent (AQUAREN 1488 manufactured by Kyoeisha) were added. The vessel was closed and rotated at a revolution speed of 500 rpm for 5 minutes in one direction. Such a pulverization treatment was performed 4 times in total while alternately changing the rotational direction. Thereafter, the pulverizing beads were removed by filtration to obtain a photosensitive dispersion. The thus obtained photosensitive dispersions were as shown in Table 1. The average particle diameter of the fine particles in the dispersions was 0.51 to 0.72 µm.

**Table 1**

| Preparation of Dispersions of Photo-Acid Former and Sensitizer | | | |
|---|---|---|---|
| Example | Dispersant: PVA solution | Photo-acid former and Amount added | Sensitizer and Amount added |
| 1 | 10 parts by weight | Tribromomethylphenylsulfone: 4 parts by weight | |
| 2 | 10 parts bv weight | Bis(tert-phenyl)iodonium hexafluorophosphate: 4 parts bv weight | |
| 3 | 10 parts by weight | 3-Methoxyphenylamine-4-diazonium hexafluorophosphate: 4 parts by weight | |
| 4 | 10 parts by weight | 2-(p-methoxyphenyl)4,6-bistrichloromethyltriazine: 4 parts by weight | |
| 5 | 10 parts by weight | 2-{2-(p-methoxyphenyl)ethenyl}4,6-bistrichloromethyltriazine: 4 parts by weight | |
| 6 | 10 parts by weight | Dimethylphenacyl phosphonium tetra(pentafluorophenyl)borate: 4 parts by weight | |
| 7 | 10 parts by weight | | 2-chlorothioxantone: 1 part |
| 8 | 10 parts bv weight | Tribromomethylphenyl sulfone: 4 parts by weight | 9,10-diethoxyanthracene: 1 part by weight |
| 9 | 10 parts by weight | Tribromomethylphenyl sulfone: 4 parts by weight | Bis(p-diethylamino)benzophenone: 1 part by weight |
| 10 | 10 parts bv weight | Tribromomethylphenyl sulfone: 4 parts by weight | 3,3-Carbonylbis(7-diethylaminocoumarin): 1 part by weight |
| 11 | 10 parts by weight | Tribromomethylphenyl sulfone: 4 parts by weight | 2-Chlorothioxanthone: 1 part by weight |
| 12 | 10 parts by weight | Bis(tert-phenyl)iodonium hexafluorophosphate: 4 parts by weight | 3,3-Carbonylbis(7-diethylaminocoumarin): 1 part by weight |

### Examples 13 to 56

### Preparation of Photosensitive Compositions:

While stirring the dispersion of the photo-acid former or sensitizer obtained in each of Examples 1 to 12, an acid-reactive insolubilizing agent and an aqueous solution of a binder resin were added thereto. As the acid-reactive insolubilizing agent, N-methylolacrylamide (manufactured by Soken Chemical Co., Ltd.), methylolmelamine (M-3, manufactured by Sumitomo Chemical Co., Ltd.), resol resin (RESITOP PL-4668, manufactured by Gun-ei Chemical Industry Co., Ltd.), methylolated urea (EX-211 or EX-321, manufactured by Nagase Chemtex Inc.) or an oxetane compound (OXT-121, manufactured by Toa Gosei Co., Ltd.) was used. As an acrylic monomer, ethylene glycol diacrylate (PET-30, manufactured by Nippon Kayaku Co., Ltd.) was used. As the binder resin, a 15 % by weight aqueous solution of K-217 (manufactured by Kuraray Co., Ltd) or a 10 % by weight aqueous solution of poly(vinyl alcohol) (PVA-SbQ) containing 1.4 mole % stilbazolium substituent was used. As a resin emulsion, HA-100 manufactured by Clariant Polymer Co., Ltd. was used. To each of these photosensitive compositions, FL-GB blue (manufactured by Dainichiseika Kogyo Co., Ltd.) was added. The thus obtained photosensitive compositions were as shown in Tables 2 to 5.

**Table 2 Preparation of Photosensitive Compositions**

| Example | Photo-acid former dispersion | Acid-reactive insolubilizing agent | Binder resin |
|---|---|---|---|
| 13 | Sample of Example 1: 1 part by weight | N-methylolacrylamide: 1.5 parts by weight | K-217Aqueous solution: 100 parts by weight |
| | Sample of Example 7: 1 part by weight | | |
| 14 | Sample of Example 1: 1 part by weight | Methylol melamine: 1.5 parts by weight | K-217Aqueous solution: 100 parts by weight |
| | Sample of Example 7: 1 part by weight | | |
| 15 | Sample of Example 1: 1 part by weight | Methylolated urea: 1.5 parts by weight | K-217Aqueous solution: 100 parts by weight |
| | Sample of Example 7: 1 part by weight | | |
| 16 | Sample of Example 1: 1 part by weight | Resol resin: 1.5 parts by weight | K-217Aqueous solution: 100 parts bv weight |
| | Sample of Example 7: 1 part by weight | | |
| 17 | Sample of Example 1: 1 part by weight | N-methylol acrylamide: 1.5 parts by weight | Aqueous solution of PVA-SbQ: 10 parts by weight |
| | Sample of Example 7: 1 part by weight | | |
| 18 | Sample of Example 2: 1 part by weight | N-methylol acrylamide: 1.5 parts by weight | K-217Aqueous solution: 100 parts by weight |
| | Sample of Example 7: 1 part by weight | | |
| 19 | Sample of Example 2: 1 part by weight | Methylolated urea: 1.5 parts by weight | K-217Aqueous solution: 100 parts by weight |
| | Sample of Example 7: 1 part by weight | | |
| 20 | Sample of Example 2: 1 part by weight | Resol resin: 1.5 parts by weight | K-217Aqueous solution: 100 parts bv weight |
| | Sample of Example 7: 1 part by weight | | |

**Table 3 Preparation of Photosentive Compositions**

| Example | Photo-acid former dispersion | Acid-reactive insolubilizing agent | Binder resin |
|---|---|---|---|
| 21 | Sample of Example 2: 1 part by weight | Epoxy compound: 40 parts by weight | K-217Aqueous solution: 100 parts by weight |
| | Sample of Example 7: 1 part by weight | Oxetane compound: 10 parts by weight | |
| 22 | Sample of Example 3: 1 part by weight | N-methylolacrylamide: 1.5 parts by weight | K-217Aqueous solution: 100 parts by weight |
| 23 | Sample of Example 3: 1 part by weight | Methylol melamine: 1.5 parts by weight | K-217Aqueous solution: 100 parts by weight |
| 24 | Sample of Example 3: 1 part by weight | Methylolated urea: 1.5 parts by weight | K-217Aqueous solution: 100 parts by weight |
| 25 | Sample of Example 3: 1 part by weight | Resol resin: 1.5 parts by weight | K-217Aqueous solution: 100 parts by weight |
| 26* | Sample of Example 3: 1 part by weight | Epoxy compound: 40 parts by weight | K-217Aqueous solution: 100 parts by weight |
| 27 | Sample of Example 3: 1 part by weight | N-methylol acrylamide: 1.5 parts by weight | K-217Aqueous solution: 100 parts by weight |
| | | Terephthalaldehyde bisdiethyl acetal: 1.5 parts by weight | |
| 28 | Sample of Example 4: 1 part by weight | N-methylol acrylamide: 1.5 parts by weight | K-217Aqueous solution: 100 parts by weight |
| 29 | Sample of Example 4: 1 part by weight | Methylol melamine: 1.5 parts by weight | K-217Aqueous solution: 100 parts by weight |
| 30 | Sample of Example 4: 1 part by weight | Methylolated urea: 1.5 parts by weight | K-217Aqueous solution: 100 parts by weight |
| 31 | Sample of Example 4: 1 part by weight | Resol resin: 1.5 parts by weight | K-217Aqueous solution: 100 parts by weight |
| 32 | Sample of Example 5: 1 part by weight | N-methylol acrylamide: 1.5 parts by weight | K-217Aqueous solution: 100 parts by weight |
| 33 | Sample of Example 5: 1 part by weight | Methylol melamine: 1.5 parts by weight | K-217Aqueous solution: 100 parts by weight |
| 34 | Sample of Example 5: 1 part by weight | Methylol melamine: 1.5 parts by weight | K-217Aqueous solution: 100 parts by weight |
| | | Pentaerythrytol acrylate: 1.5 parts by weight | |
| 35 | Sample of Example 5: 1 part by weight | Resol resin: 1.5 parts by weight | K-217Aqueous solution: 100 parts by weight |

| | | | |
|---|---|---|---|
| * not according to the invention | | | |

**Table 4 Preparation of Photosentive Compositions**

| Example | Photo-acid former dispersion | Acid-reactive insolubilizing agent | Binder resin |
|---|---|---|---|
| 36 | Sample of Example 6: 1 part by weight | N-methylol acrylamide: 1.5 parts by weight | K-217Aqueous solution:100 parts by weight |
| | | Diethylene glycol diacrylate: 1.5 parts by weight | |
| 37 | Sample of Example 6: 1 part by weight | Resol resin: 1.5 parts by weight | K-217Aqueous solution:100 parts by weight |
| 38* | Sample of Example 6: 1 part by weight | Epoxy compound: 40 parts by weight | K-217Aqueous solution:100 parts by weight |
| 39 | Sample of Example 8: 1 part by weight | N-methylol acrylamide: 1.5 parts by weight | K-217Aqueous solution:100 parts by weight |
| 40 | Sample of Example 8: 1 part by weight | Methylolated urea: 1.5 parts by weight | K-217Aqueous solution:100 parts by weight |
| 41 | Sample of Example 9: 1 part by weight | Methylolated urea: 1.5 parts by weight | K-217Aqueous solution:100 parts by weight |
| 42 | Sample of Example 9: 1 part by weight | Resol resin: 1.5 parts by weight | K-217Aqueous solution:100 parts by weight |
| 43 | Sample of Example 10: 1 part by weight | N-methylol acrylamide: 1.5 parts by weight | K-217Aqueous solution:100 parts by weight |
| 44 | Sample of Example 10: 1 part by weight | Methylolated urea: 1.5 parts by weight | K-217Aqueous solution:100 parts by weight |
| 45 | Sample of Example 11: 1 part by weight | N-methylol acrylamide: 1.5 parts by weight | K-217Aqueous solution:100 parts by weight |
| 46 | Sample of Example 11: 1 part by weight | Resol resin: 1.5 parts by weight | K-217Aqueous solution:100 parts by weight |
| 47 | Sample of Example 12: 1 part by weight | N-methylol acrylamide: 1.5 parts by weight | K-217Aqueous solution:100 parts by weight |
| 48 | Sample of Example 12: 1 part by weight | Methylol melamine: 1.5 parts by weight | K-217Aqueous solution:100 parts by weight |
| 49 | Sample of Example 12: 1 part by weight | Resol resin: 1.5 parts by weight | K-217Aqueous solution:100 parts by weight |
| 50* | Sample of Example 12: 1 part by weight | Epoxy compound: 40 parts by weight | K-217Aqueous solution:100 parts by weight |
| 51* | Sample of Example 12: 1 part by weight | Epoxy compound: 20 parts by weight | K-217Aqueous solution:100 parts by weight |
| | | Diethylene glycol diacrylate: 20 parts by weight | |

| | | | |
|---|---|---|---|
| * not according to the invention | | | |

**Table 5**

| Example | Photo-acid former dispersion | Acid-reactive insolubilizing agent | Resin emulsion | Binder resin |
|---|---|---|---|---|
| 52 | Sample of Example 8: 1 part by weight | N-methylol acrylamide: 1.5 parts by weight | HA-10: 15 parts By weight | K-217Aqueous solution: 100 parts by weight |
| 53 | Sample of Example 8: 1 part by weight | Methylolated urea: 1.5 parts by weight | HA-10: 15 parts Bv weight | K-217Aqueous solution: 100 parts bv weight |
| 54 | Sample of Example 8: 1 part by weight | Resol resin: 1.5 parts by weight | HA-10: 15 parts By weight | K-217Aqueous solution: 100 parts by weight |
| 55 | Sample of Example 9: 1 part by weight | N-methylol acrylamide: 1.5 parts by weight | HA-10: 15 parts By weight | K-217Aqueous solution: 100 parts by weight |
| 56 | Sample, of Example 10: 1 part by weight | Methylol melamine: 1.5 parts by weight | HA-10: 15 parts By weight | K-217Aqueous solution: 100 parts by weight |

### Comparative Examples 1 to 4

Photosensitive compositions prepared without using the acid-reactive insolubilizing agent or using only a radically polymerizable monomer are shown in Table 6 as comparative examples.

**Table 6 Preparation of Photosensitive Films**

| Comparative Example | Photo-acid former dispersion | Additive | Binder resin |
|---|---|---|---|
| 1 | Sample of Example 3: 1 part by weight | None | K-217Aqueous solution: 100 parts by weight |
| 2 | Sample of Example 3: 1 part by weight | Diethylene glycol diacrylate: 15 parts by weight | K-217Aqueous solution: 100 parts by weight |
| 3 | Sample of Example 8: 1 part by weight | Diethylene glycol diacrylate: 20 parts by weight | K-217Aqueous solution: 100 parts by weight |
| 4 | Sample of Example 10: 1 part by weight | Diethylene glycol diacrylate: 20 parts by weight | K-217Aqueous solution: 100 parts by weight |

### Examples 57 to 104

### Preparation of Photosensitive Films and Photosensitization Characteristics:

The photosensitive compositions obtained in Examples 13 to 56 were each applied onto a polyester film. The coatings were dried at 40°C for 15 minutes to obtain photosensitive films having thicknesses of 25 to 30 µm. Each film was irradiated through a photomask placed in contact therewith using a 4 KW high pressure mercury lamp or a 3 KW halogen lamp spaced a distance of 1 m away therefrom. After irradiation, water was sprayed thereon using a spray gun to effect development. Prior to the development with water, a heat treatment was carried out for given temperature and time, when needed. The results are summarized in Tables 7 and 8, in which the evaluation of image formation is rated as follows:
yes: negative pattern is obtained
no: pattern is not formed

Good patterns were obtained when the acid-reactive insolubilizing agent was used. When no acid-reactive insolubilizing agent was added or when only a radically polymerizable monomer was added, negative patterns were not obtained.

**Table 7 Photosensitization Characteristics of Films obtained from Photosensitive Compositions**

| Example | Photosensitive Composition Preparation Example | Light Source | Exposure Time (min.) | Heat treatment condition | Image formation |
|---|---|---|---|---|---|
| 57 | Example 13 | Mercury lamp | 3 | 80 °C, 10 minutes | A |
| 58 | Example 14 | Mercury lamp | 3 | 80 °C, 10 minutes | A |
| 59 | Example 15 | Mercury lamp | 3 | 40 ° C, 20 minutes | A |
| 60 | Example 16 | Mercury lamp | 3 | 40 ° C, 20 minutes | A |
| 61 | Example 17 | Mercury lamp | 2 | 40°C, 20 minutes | A |
| 62 | Example 18 | Halogen lamp | 3 | 40 °C, 20 minutes | A |
| 63 | Example 19 | Halogen lamp | 3 | 40°C, 20 minutes | A |
| 64 | Example 20 | Halogen lamp | 3 | 40 ° C, 20 minutes | A |
| 65 | Example 21 | Halogen lamp | 3 | Room temperature 120 minutes | A |
| 66 | Example 22 | Mercury lamp | 2.5 | 80 ° C, 10 minutes | A |
| 67 | Example 23 | Mercury lamp | 2.5 | 80 ° C, 10 minutes | A |
| 68 | Example 24 | Mercury lamp | 2.5 | 40 ° C, 20 minutes | A |
| 69 | Example 25 | Mercury lamp | 2.5 | 40°C, 20 minutes | A |
| 70 | Example 26 | Mercury lamp | 2.5 | 40 °C, 20 minutes | A |
| 71 | Example 27 | Mercury lamp | 2.5 | 40 ° C, 20 minutes | A |
| 72 | Example 28 | Mercury lamp | 4 | 80 ° C, 5 minutes | A |
| 73 | Example 29 | Mercury lamp | 3 | 80 °C, 5 minutes | A |
| 74 | Example 30 | Mercury lamp | 3 | 80 ° C, 5 minutes | A |
| 75 | Example 31 | Mercury lamp | 3 | 80°C, 5 minutes | A |
| 76 | Example 32 | Mercury lamp | 3 | 80°C, 5 minutes | A |
| 77 | Example 33 | Mercury lamp | 2.5 | 80 °C, 5 minutes | A |
| 78 | Example 34 | Mercury lamp | 2.5 | 80 °C, 5 minutes | A |
| 79 | Example 35 | Mercury lamp | 2.5 | 40 ° C, 20 minutes | A |
| 80 | Example 36 | Mercury lamp | 1 | 40 ° C, 20 minutes | A |

**Table 8 Photosensitization Characteristics of Films obtained from Photosensitive Compositions**

| Example | Photosensitive Composition Preparation Example | Light Source | Exposure Time (min.) | Heat treatment condition | Image formation |
|---|---|---|---|---|---|
| 81 | Example 37 | Mercury lamp | 2.5 | 40°C, 20 minutes | A |
| 82 | Example 38 | Mercury lamp | 2 | 40°C, 20 minutes | A |
| 83 | Example 39 | Halogen lamp | 2 | 40 °C, 20 minutes | A |
| 84 | Example 40 | Halogen lamp | 2 | 40°C, 20 minutes | A |
| 85 | Example 41 | Halogen lamp | 1.5 | 80°C, 20 minutes | A |
| 86 | Example 42 | Halogen lamp | 1.5 | 40°C, 20 minutes | A |
| 87 | Example 43 | Halogen lamp | 1.5 | 40 °C, 20 minutes | A |
| 88 | Example 44 | Halogen lamp | 1 | Room temperature 120 minutes | A |
| 89 | Example 45 | Mercury lamp | 3 | 40°C, 20 minutes | A |
| 90 | Example 46 | Mercury lamp | 3 | 40°C, 20 minutes | A |
| 91 | Example 47 | Mercury lamp | 1 | 40 ° C, 20 minutes | A |
| 92 | Example 48 | Mercury lamp | 1 | 80 °C, 10 minutes | A |
| 93 | Example 49 | Mercury lamp | 1 | 80°C, 10 minutes | A |
| 94 | Example 50 | Mercury lamp | 1 | 40 °C, 20 minutes | A |
| 95 | Example 51 | Mercury lamp | 1 | 40°C, 20 minutes | A |
| 96 | Example 52 | Mercury lamp | 2 | 40 ° C, 20 minutes | A |
| 97 | Example 53 | Mercury lamp | 2 | 80°C, 10 minutes | A |
| 98 | Example 54 | Mercury lamp | 2 | 80 °C, 10 minutes | A |
| 99 | Example 55 | Mercury lamp | 1.5 | 40 ° C, 20 minutes | A |
| 100 | Example 56 | Mercury lamp | 1 | 40°C, 20 minutes | A |
| 101 | Comparative Example 1 | Mercury lamp | 10 | 40 °C, 20 minutes | B |
| 102 | Comparative Example 2 | Mercury lamp | 5 | 40 ° C, 20 minutes | B |
| 103 | Comparative Example 3 | Mercury lamp | 10 | 40 ° C, 20 minutes | B |
| 104 | Comparative Example 4 | Mercury lamp | 5 | 80°C, 10 minutes | B |

### Examples 105 to 117

### Preparation of Films for Screen Platemaking and Photosensitization Characteristics:

The photosensitive compositions obtained in the above examples were each applied onto a 250 mesh polyester screen and then dried. Such application and drying operations were repeated to obtain uniform films having thicknesses of about 15 µm. Each film was irradiated through a photomask placed in contact therewith using a 4 KW high pressure mercury lamp or a 3 KW halogen lamp spaced a distance of 1 m away therefrom. After irradiation, water was sprayed thereon using a spray gun to effect development. Prior to the development with water, a heat treatment was carried out for given temperature and time, when needed. The results are shown in Table 9. The patterns obtained exhibited good water resistance and show good resistance against organic solvents such as toluene, acetone, ethyl acetate and butyl cellosolve. When the compositions of Comparative Examples were used, however, patterns were not formed by water development after the exposure.

**Table 9 Sensitization Characteristics of Films for Screen Platemaking obtained from Photosensitive Composition**

| Example | Photosensitive Composition Preparation Example | Light Source | Exposure Time (min.) | Heat treatment condition | Image Formation | Water Resistance | Solvent resistance |
|---|---|---|---|---|---|---|---|
| 105 | Example 13 | Mercury lamp | 3 | 40 ° C, 20 minutes | A | A | A |
| 106 | Example 21 | Mercury lamp | 3 | 40 °C, 20 minutes | A | A | A |
| 107 | Example 22 | Mercury lamp | 3 | 40 ° C, 20 minutes | A | A | A |
| 108 | Example 26 | Mercury lamp | 4 | 40 ° C, 30 minutes | A | A | A |
| 109 | Example 28 | Mercury lamp | 1 | 40 ° C, 20 minutes | A | A | A |
| 110 | Example 36 | Mercury lamp | 2 | 40 ° C, 20 minutes | A | A | A |
| 111 | Example 38 | Mercury lamp | 2 | 40 ° C, 20 minutes | A | A | A |
| 112 | Example 42 | Mercury lamp | 1.5 | 40 °C, 20 minutes | A | A | A |
| 113 | Example 50 | Mercury lamp | 2 | 40 ° C, 30 minutes | A | A | A |
| 114 | Example 51 | Mercury lamp | 2 | 40 ° C, 30 minutes | A | A | A |
| 115 | Example 52 | Mercury lamp | 1.5 | 40 °C, 20 minutes | A | A | A |
| 116 | Comp. Example 1 | Mercury lamp | 10 | 40 ° C, 20 minutes | B | B | B |
| 117 | Comp. Example 1 | Mercury lamp | 10 | 40 ° C, 20 minutes | B | B | B |

## Claims

1. An activation energy ray-sensitive resin composition comprising:
water,
a water-soluble resin dissolved in the water,
an acid former, in the form of solid particles, dispersed in the water and generating an acid when irradiated with activation energy rays,
a sensitizer, in the form of solid particles, dispersed in the water for sensitizing the acid generation by the acid former, and
an acid-reactive insolubilizing agent dissolved or dispersed in the water and capable of insolubilizing said water-soluble resin by reaction therewith in the presence of said acid, wherein said acid-reactive insolubilizing agent is an N-methylolated or N-alkoxymethylated nitrogen-containing compound, a hydroxymethylated phenol derivative or a resol resin; a compound having at least one oxetane group, vinyloxy group, isopropenyloxy group or orthoester group; or a compound having at least one formyl group, wherein each of said acid former and sensitizer has an average particle diameter of 1.5 µm or less.

2. The composition as recited in claim 1, further comprising a compound having at least one radically polymerizable unsaturated bond and dissolved or dispersed in the water.

3. The composition as recited in claim 1, wherein said acid-reactive insolubilizing agent is a mixture of a compound, having at least one oxetane group with a compound having at least one epoxy group.

4. The composition as recited in any preceding claim, further comprising an aqueous resin emulsion.

5. The composition as recited in any preceding claim, further comprising a water-soluble, photo-insolubilizable resin.

6. The composition as recited in claim 5, wherein said water-soluble, photo-insolubilizable resin is a photo-crosslinkable polyvinyl alcohol containing a styrylpyridinium group represented by the following formula (1): 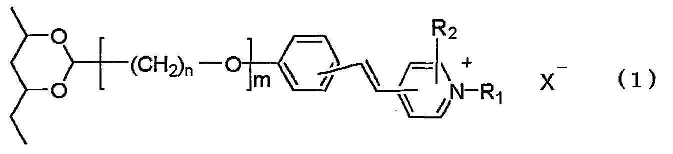 wherein R₁ represents a hydrogen atom, an alkyl group or an aralkyl group, R₂ represents a hydrogen atom or a lower alkyl group, X⁻ represents a halogen ion, a phosphate ion, a p-toluenesulfonate ion or a mixture of these anions, m is a number of 0 or 1 and n is an integer of 1 to 6.

7. The composition as recited in claim 5, wherein said water-soluble, photo-insolubilizable resin comprises polyvinyl alcohol, casein or gelatin, and a water-soluble diazo resin or a dichromate.

8. The composition as recited in any preceding claim, wherein said acid-reactive insolubilizing agent is present in an amount of 5 to 1,000 parts by weight per 100 parts by weight of said water-soluble resin, said acid former is present in an amount of 1 to 100 parts by weight per 100 parts by weight of said acid-reactive insolubilizing agent, and said sensitizer is present in an amount of 5 to 100 parts by weight per 100 parts by weight of said acid former.

9. The composition as recited in any preceding claim, wherein each of said acid former and sensitizer has an average particle diameter of 0.8 µm or less.

10. An activation energy ray-sensitive resin film obtainable by drying a layer of the composition according to any one of claims 1 through 9.

11. Use of the resin film of claim 10 for screen printing process.

12. A pattern forming method comprising the steps of:
irradiating an activation energy ray-sensitive resin film according to claim 10 with activation energy rays, and
developing the activation energy ray-irradiated film with water.

13. A pattern forming method as recited in claim 12, further comprising heating the activation energy ray-irradiated film before said developing with water.

## Patentansprüche

1. Aktivierungsenergiestrahlenempfindliche Harzzusammensetzung aufweisend:
Wasser,
ein im Wasser gelöstes wasserlösliches Harz,
einen Säurebildner in der Form von festen Partikeln, der im Wasser dispergiert ist und eine Säure generiert, wenn er mit Aktivierungsenergiestrahlen bestrahlt wird,
einen Sensibilisator in Form von festen Partikeln, der im Wasser zum Sensibilisieren der Säuregenerierung durch den Säurebildner dispergiert ist, und
ein säurereaktives Insolubilisierungsmittel, das im Wasser gelöst oder dispergiert ist und in der Lage ist, das wasserlösliche Harz durch Reaktion damit in Gegenwart der Säure zu insolubilisieren, wobei das säurereaktive Insolubilisierungsmittel eine N-methylolierte oder N-alkoxymethylierte Stickstoff enthaltende Verbindung ist, ein hydroxymethyliertes Phenolderivat oder ein Resolharz; eine Verbindung mit wenigstens einer Oxetangruppe, Vinyloxygruppe, Isopropenyloxygruppe oder Orthoestergruppe; oder eine Verbindung, die wenigstens eine Formylgruppe hat, wobei jeder der genannten Säurebildner und Sensibilisatoren einen mittleren Partikeldurchmesser von 1,5 µm oder weniger hat.

2. Zusammensetzung nach Anspruch 1, weiterhin aufweisend eine Verbindung mit wenigstens einer radikalisch polymerisierbaren ungesättigten Bindung und gelöst oder dispergiert im Wasser.

3. Zusammensetzung nach Anspruch 1, wobei das säurereaktive Insolubilisierungsmittel eine Mischung einer Verbindung ist, die wenigstens eine Oxetangruppe hat, mit einer Verbindung, die wenigstens eine Epoxygruppe hat.

4. Zusammensetzung nach einem der vorhergehenden Ansprüche, weiterhin aufweisend eine wässrige Harzemulsion.

5. Zusammensetzung nach einem der vorhergehenden Ansprüche, weiterhin aufweisend ein wasserlösliches photoinsolubilisierbares Harz.

6. Zusammensetzung nach Anspruch 5, wobei das wasserlösliche photoinsolubilisierbare Harz ein photovernetzbarer Polyvinylalkohol ist, der eine Styrolpyridiniumgruppe enthält, dargestellt durch die folgende Formel (1): 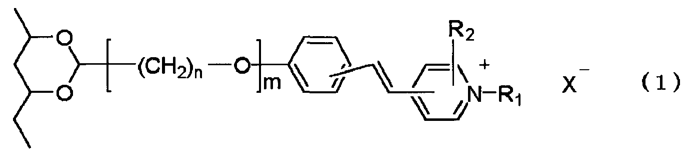 worin R₁ ein Wasserstoffatom, eine Alkylgruppe oder eine Aralkylgruppe darstellt, R₂ ein Wasserstoffatom oder eine niedere Alkylgruppe darstellt, X- ein Halogenion, ein Phosphation, ein p-Toluolsulfonation oder eine Mischung von diesen Ionen darstellt, m eine Zahl von 0 oder 1 ist und n eine ganze Zahl von 1 bis 6 ist.

7. Zusammensetzung nach Anspruch 5, wobei das wasserlösliche photoinsolubilisierbare Harz Polyvinylalkohol, Casein oder Gelatine, und ein wasserlösliches Diazoharz oder ein Dichromat aufweist.

8. Zusammensetzung nach einem der vorhergehenden Ansprüche, wobei das säurereaktive Insolubilisierungsmittel in einer Menge von 5 bis 1.000 Gewichtsteilen pro 100 Gewichtsteile des wasserlöslichen Harzes vorhanden ist, wobei der Säurebildner in einer Menge von 1 bis 100 Gewichtsteilen pro 100 Gewichtsteile des säurereaktiven Insolubilisierungsmittels vorhanden ist, und der Sensibilisierer in einer Menge von 5 bis 100 Gewichtsteilen pro 100 Gewichtsteile des Säurebildners vorhanden ist.

9. Zusammensetzung nach einem der vorhergehenden Ansprüche, wobei der Säurebildner und Sensibilisierer jeweils einen mittleren Partikeldurchmesser von 0,8 µm oder weniger haben.

10. Ein aktivierungsenergiestrahlenempfindlicher Harzfilm, erhältlich durch Trocknen einer Schicht der Zusammensetzung nach einem der Ansprüche 1 bis 9.

11. Verwendung es Harzfilms nach Anspruch 9 für Siebdruckverfahren.

12. Bildformverfahren, aufweisend die Schritte, dass man:
einen aktivierungsenergiestrahlenempfindlichen Harzfilm nach Anspruch 10 mit Aktivierungsenergiestrahlen bestrahlt, und
den Aktivierungsenergiestrahlen bestrahlten Film mit Wasser entwickelt.

13. Bildformverfahren nach Anspruch 12, weiterhin aufweisend, dass man den Aktivierungsenergiestrahlen bestrahlten Film erhitzt, bevor man ihn mit Wasser entwickelt.

## Revendications

1. Composition de résine sensible au rayonnement d'énergie d'activation comprenant :
de l'eau,
une résine soluble dans l'eau dissoute dans l'eau,
un générateur d'acide, sous la forme de particules solides, dispersé dans l'eau et générant un acide quand il est exposé à des rayonnements d'énergie d'activation,
un sensibilisateur, sous la forme de particules solides, dispersé dans l'eau pour sensibiliser la génération d'acide par le générateur d'acide, et
un agent d'insolubilisation réactif à l'acide dissous ou dispersé dans l'eau et capable d'insolubiliser ladite résine soluble dans l'eau par réaction avec celle-ci en présence dudit acide, dans laquelle ledit agent d'insolubilisation réactif à l'acide est un composé contenant de l'azote N-méthylolé ou N-alcoxyméthylé, un dérivé de phénol hydroxyméthylé ou une résine résol ; un composé ayant au moins un groupe oxétane, un groupe vinyloxy, un groupe isopropényloxy ou un groupe orthoester ; ou un composé ayant au moins un groupe formyle, dans laquelle ledit générateur d'acide et ledit sensibilisateur ont chacun un diamètre de particule moyen de 1,5 µm ou moins.

2. Composition selon la revendication 1, comprenant en outre un composé ayant au moins une liaison non saturée radicalement polymérisée et dissous ou dispersé dans l'eau.

3. Composition selon la revendication 1, dans laquelle ledit agent d'insolubilisation réactif à l'acide est un mélange d'un composé, ayant au moins un groupe oxétane avec un composé ayant au moins un groupe époxy.

4. Composition selon l'une quelconque des revendications précédentes, comprenant en outre une émulsion de résine aqueuse.

5. Composition selon l'une quelconque des revendications précédentes, comprenant en outre une résine photo-insolubilisable et soluble dans l'eau.

6. Composition selon la revendication 5, dans laquelle ladite résine photo-insolubilisable et soluble dans l'eau est un alcool polyvinylique photo-réticulable contenant un groupe styrylpyridinium représenté par la formule suivante (1) : 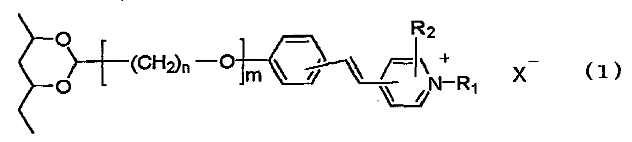 dans laquelle R₁ représente un atome d'hydrogène, un groupe alkyle ou un groupe aralkyle, R₂ représente un atome d'hydrogène ou un groupe alkyle inférieur, X⁻ représente un ion halogène, un ion phosphate, un ion p-toluènesulfonate ou un mélange de ces anions, m est un nombre de 0 ou 1 et n est un entier de 1 à 6.

7. Composition selon la revendication 5, dans laquelle ladite résine photo-insolubilisable et soluble dans l'eau comprend de l'alcool polyvinylique, de la caséine ou de la gélatine, et une résine diazo soluble dans l'eau ou un dichromate.

8. Composition selon l'une quelconque des revendications précédentes, dans laquelle ledit agent d'insolubilisation réactif à l'acide est présent en une quantité de 5 à 1000 parts en poids pour 100 parts en poids de ladite résine soluble dans l'eau, ledit générateur d'acide est présent en une quantité de 1 à 100 parts en poids pour 100 parts en poids dudit agent d'insolubilisation réactif à l'acide, et ledit sensibilisateur est présent en une quantité de 5 à 100 parts en poids pour 100 parts en poids dudit générateur d'acide.

9. Composition selon l'une quelconque des revendications précédentes, dans laquelle ledit générateur d'acide et ledit sensibilisateur ont chacun un diamètre de particule moyen de 0,8 µm ou moins.

10. Film de résine sensible au rayonnement d'énergie d'activation pouvant être obtenu par le séchage d'une couche de la composition selon l'une quelconque des revendications 1 à 9.

11. Utilisation du film de résine selon la revendication 10 pour procédé de sérigraphie.

12. Procédé de formation de motif comprenant les étapes consistant à :
exposer un film de résine sensible au rayonnement d'énergie d'activation selon la revendication 10 avec des rayonnements d'énergie d'activation, et
développer le film exposé aux rayonnements d'énergie d'activation avec de l'eau.

13. Procédé de formation de motif selon la revendication 12, comprenant en outre le chauffage du film exposé aux rayonnements d'énergie d'activation avant ledit développement avec de l'eau.
